# FASCICULE DE BREVET EUROPEEN

(11) **EP 1 751 876 B1**
(45) Date de publication et mention de la délivrance du brevet: **26.01.2011**
(21) Numéro de dépôt: 05739683.0
(22) Date de dépôt: 30.03.2005
(51) Int. Cl.: H04B 1/16

(54) **PROCEDE DE COMMUTATION DE MODE D'UN OSCILLATEUR ET DISPOSITIF OSCILLATEUR CORRESPONDANT**
MODUSUMSCHALTVERFAHREN FÜR EINEN OSZILLATOR UND ENTSPRECHENDE OSZILLATOREINRICHTUNG
MODE SWITCHING METHOD FOR AN OSCILLATOR AND CORRESPONDING OSCILLATOR DEVICE

(30) Priorité: 11.05.2004 FR 0450901
(43) Date de publication de la demande: 14.02.2007
(73) Titulaire: SAGEM MOBILES, 75512 Paris (FR)
(72) Inventeur: ROMAO, Fernando, F-78360 MONTESSON (FR)
(74) Mandataire: Maillet, Alain
(86) Numéro de dépôt international: PCT/FR2005/050200
(87) Numéro de publication internationale: WO 2005/114852

(56) Documents cités:
- EP-A- 0 758 768
- WO-A-02/47247
- US-A- 5 943 613
- US-A1- 2002 010 010

## Description

### DOMAINE TECHNIQUE DE L'INVENTION

La présente invention a pour objet un procédé de commutation de mode d'un oscillateur intervenant dans un processus de génération de base de temps dans un téléphone mobile. Elle a également pour objet un dispositif oscillateur permettant la mise en oeuvre d'un tel procédé. Plus précisément, l'invention propose une solution pour permettre à un oscillateur, présent dans un dispositif oscillateur, de passer d'un premier mode de fonctionnement, correspondant à un premier niveau de consommation, à un second mode de fonctionnement, correspondant à un second niveau de fonctionnement, inférieur au premier niveau de fonctionnement, tout en maintenant une grande précision et pureté spectrale d'un signal obtenu en sortie du dispositif oscillateur.

Le domaine de l'invention est, d'une façon générale, celui de la téléphonie mobile. Dans ce domaine, il est capital de fournir une base de temps très précise aux microprocesseurs des téléphones mobiles, notamment afin qu'ils puissent se synchroniser parfaitement sur les réseaux de radiotéléphonie cellulaire dont ils dépendent. La base de temps est fournie, d'une façon générale, par des oscillateurs, par exemple des oscillateurs à quartz. Ainsi, par exemple, dans le cas du GSM, on disposait initialement d'un unique oscillateur fournissant un signal d'horloge à 13 MHz (MégaHertz) pour cadencer le fonctionnement du téléphone. Un tel oscillateur se devait de présenter en permanence une pureté spectrale élevée, et consommait en conséquence une quantité d'énergie non négligeable.

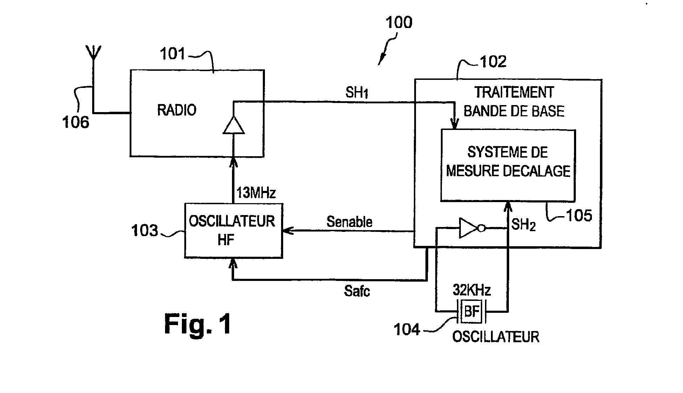

Les constructeurs de téléphone, gênés par la consommation excessive d'un tel oscillateur, se sont massivement tournés vers une architecture faisant intervenir au moins deux oscillateurs. Une représentation schématique d'un exemple d'une telle architecture est donnée à la figure 1.

Sur cette figure, un téléphone mobile 100 comporte, de façon simplifiée, un bloc radio 101 et un bloc de traitement 102 des informations en bande de base. Le bloc radio 101 sert notamment aux différentes opérations d'émission/réception réalisées au moyen du téléphone mobile. II est relié à une antenne 106. A cet effet, il doit recevoir un signal d'horloge particulièrement précis, qui est fourni par un premier oscillateur à quartz 103, dit oscillateur haute fréquence, délivrant un signal, très stable en température et dans le temps, et de grande pureté spectrale, par exemple à 13 MHz. Le premier oscillateur peut par exemple être du type VCXO (Voltage Controlled Crystal Oscillator en anglais), ou du type VTXCO (Voltage Temperature Controlled Crystal Oscillator en anglais). Dans d'autres exemples de réalisation, le premier oscillateur fournit un signal à 26 MHz.

Le bloc bande de base 102 sert notamment à interpréter un ensemble d'informations reçues par le réseau, à démoduler certains signaux reçus...II reçoit un signal d'horloge fourni par un second oscillateur à quartz 104, qui délivre un signal à une fréquence inférieure à celle du premier oscillateur, typiquement 32 KHz (kiloHertz). Le second oscillateur 104 présente une pureté spectrale, une fréquence plus basse et une stabilité moins bonne que le premier oscillateur, ce qui lui permet notamment de moins consommer. Il est notamment utilisé comme base de temps pour l'horloge calendaire du téléphone mobile.

On distingue essentiellement trois états d'utilisation d'un téléphone mobile: un premier état, dit état arrêt, dans lequel le téléphone est éteint et ne peut pas recevoir d'appel ; un deuxième état, dit état de veille, dans lequel un utilisateur du téléphone n'est pas en train de communiquer au moyen de son téléphone, mais dans lequel l'utilisateur est joignable sur son téléphone ; un troisième état, dit état de communication, dans lequel l'utilisateur utilise le téléphone pour communiquer. Typiquement, lorsqu'un téléphone mobile est dans l'état de veille, il doit continuer à avoir une activité, dite activité de veille : il doit notamment surveiller son canal de paging, afin de pouvoir être joint en permanence, et assurer des tâches de monitoring, consistant en différentes opérations de mesures et de détection de signaux sur des cellules voisines de celle sur laquelle il est raccordé.

Les phases d'activité de l'état de veille du téléphone mobile nécessitent l'utilisation du premier oscillateur 103. Cependant, ces phases d'activité de l'état de veille ne sont pas permanentes : les tâches de paging et de monitoring sont périodiques et ont lieu à des instants parfaitement définis. Afin de limiter la consommation en énergie, notamment pendant l'état de veille, on a proposé d'utiliser le premier oscillateur uniquement pendant les phases d'activité de l'état de veille où sa haute fréquence était indispensable. Le reste du temps, dans l'état de veille, seul le second oscillateur 104 est utilisé. A cet effet, un signal d'activation/désactivation S_{enable} du premier oscillateur 103 est transmis par le bloc de traitement 102 au premier oscillateur. Ce signal commande la mise en marche et l'arrêt du premier oscillateur 103. Le premier oscillateur 103 reçoit par ailleurs un signal dit de contrôle automatique en fréquence S_{afc} dont le rôle sera détaillé ultérieurement.

Pendant les phases d'inactivité de l'état de veille, le second oscillateur assure le maintien de la base de temps pour permettre de garder une synchronisation avec le réseau de radiotéléphonie cellulaire avec lequel le téléphone considéré est relié. En dehors des phases d'activité de l'état de veille, il est donc important de savoir quel est le calage en fréquence du second oscillateur 104 par rapport au premier oscillateur 103. A cet effet, on prévoit l'existence d'un système de mesure 105 du décalage du second oscillateur 104 par rapport au premier oscillateur 103. Le système de mesure 105 reçoit donc, pendant que le téléphone mobile est en état de communication, et éventuellement pendant les phases d'activité de l'état de veille, un premier signal S_{H1} correspondant au signal émis par le premier oscillateur 103, et un second signal S_{H2} correspondant au signal émis par le second oscillateur 104, pour effectuer par exemple un étalonnage du second signal par le premier signal. On s'affranchit ainsi des dérives du second oscillateur 104, et on dispose donc, pendant les phases d'inactivité du état de veille, d'un signal d'horloge procurant une base de temps, dont on maîtrise parfaitement les caractéristiques et qui permet de garder une synchronisation avec le réseau.

### ARRIERE-PLAN TECHNOLOGIQUE DE L'INVENTION

Une telle solution pour limiter la forte consommation de courant liée à la présence de l'oscillateur haute fréquence n'est cependant pas satisfaisante ; elle présente en effet un certain nombre de problèmes :
Tout d'abord, il est nécessaire, dans la solution qui vient d'être décrite, d'utiliser deux oscillateurs à quartz, ce qui, d'une part, augmente le volume occupé par le dispositif de génération de base de temps - handicap non négligeable dans le domaine de la téléphonie mobile où les constructeurs s'évertuent à miniaturiser l'ensemble des éléments intervenant - , et d'autre part augmente le coût de fabrication d'un-tel dispositif.

De plus, la présence d'un système de mesure du décalage entre le premier et le second oscillateur augmente le coût de fabrication du téléphone mobile

Enfin, l'oscillateur haute fréquence intervenant dans la solution décrite consomme, dès qu'il est actif, une quantité importante d'énergie ; et, comme on l'a vu, l'oscillateur haute fréquence est utilisé non seulement dans l'état de communication, mais aussi pendant certaines phases de l'état de veille.

Le fonctionnement des téléphones mobiles de l'état de la technique n'est donc pas totalement satisfaisant au niveau de la consommation des dispositifs oscillateurs permettant de générer une base de temps du téléphone: d'une part, la présence d'un second oscillateur à quartz et d'un système de mesure du décalage entre le premier et le second oscillateur augmente le coût de fabrication du téléphone mobile ; d'autre part, la consommation du téléphone mobile pendant les périodes de veille pourrait encore être améliorée, notamment si on parvenait à provoquer une modification du niveau d'alimentation de l'oscillateur haute fréquence pendant une phase de transition au cours de laquelle le téléphone mobile passe de l'état de communication à l'état de veille sans pour autant affecter la qualité du signal produit par le premier oscillateur.

Dans l'état de la technique, on connaît par ailleurs la demande de brevet PCT publiée sous le numéro WO 02/47247, qui divulgue un appareil de communication radio multimodes utilisant un unique oscillateur de référence. On connaît également l'enseignement du document EP-A-0 758 768 ; mais ces documents ne divulguent pas de solutions pour gérer des phases de transition d'un dispositif oscillateur lorsque ce dernier commute d'un mode haute consommation à un mode basse consommation, ou vice-versa.

### DESCRIPTION GENERALE DE L'INVENTION

La présente invention propose une solution aux problèmes qui viennent d'être mentionnés.

Dans l'invention, on exploite le fait qu'un oscillateur à quartz haute fréquence, du type de ceux utilisés dans les téléphones mobiles pour générer une base de temps, pourrait consommer moins, notamment lorsqu'il est utilisé dans l'état de veille : en effet, lorsque le téléphone mobile est dans un état de communication, les courants circulant dans le téléphone mobile seraient susceptibles de perturber la grande précision et la grande pureté spectrale de l'oscillateur haute fréquence si ce dernier n'avait pas un niveau de consommation important lui permettant de résister aux perturbations engendrées par ces courants. Mais quand le téléphone mobile n'est plus dans un état de communication, les courants circulant dans le téléphone mobile sont beaucoup moins importants et ne sont donc pas susceptibles de perturber la stabilité de l'oscillateur haute fréquence, même si ce dernier a un niveau de consommation plus faible. L'oscillateur haute fréquence pourrait donc être alimenté avec un niveau de consommation moins important lorsqu'il fonctionne dans l'état de veille que lorsqu'il fonctionne dans l'état de communication.

Une difficulté apparaît cependant lors de la commutation du mode de fonctionnement de l'oscillateur haute fréquence - désormais désigné comme premier oscillateur - pour le faire passer d'un premier niveau de consommation, par exemple 2 milli-ampères, à un second niveau de consommation, par exemple 100 micro-ampères ; en effet, une telle commutation implique une intervention au niveau du premier oscillateur, dont un exemple sera donné ultérieurement ; cette intervention entraîne un décalage en fréquence, pendant une phase transitoire, du premier oscillateur, ce qui est totalement incompatible avec la fonction de cet oscillateur, pour lequel une grande précision est requise. Pour remédier à cette difficulté, on propose, dans l'invention, pour générer une base de temps, de recourir pendant la phase transitoire à un second oscillateur dont les caractéristiques requises en terme de stabilité et de pureté spectrale sont nettement moins contraignantes que celles requises pour le premier oscillateur ; une fois que le fonctionnement du premier oscillateur est stabilisé, on utilise de nouveau le premier oscillateur pour fournir un signal servant de base de temps au téléphone mobile.

Grâce à l'invention, l'utilisation de l'oscillateur à 32 kHz n'est plus nécessaire. Le premier oscillateur, correspondant à l'oscillateur haute fréquence de l'état de la technique, consommant moins dans l'état de veille du téléphone mobile, celui-ci peut être utilisé en permanence dans cet état de veille - aux phases transitoires près, ces dernières marquant une entrée ou une sortie d'un état de veille - pour générer la base de temps du téléphone mobiles.

L'invention concerne donc essentiellement un procédé de commutation de mode d'un dispositif oscillateur, pour générer une base de temps d'un téléphone mobile en délivrant un signal de sortie, pour passer d'un premier mode de fonctionnement, correspondant à un premier niveau de consommation, à un second mode de fonctionnement, correspondant à un second niveau de consommation, le second niveau de consommation étant inférieur au premier niveau de consommation caractérisé en ce qu'il comporte une phase de transition, lors du passage du premier mode au second mode, comportant les différentes étapes consistant à:
- imposer, au moyen d'une première boucle à verrouillage de phase, une fréquence de fonctionnement d'un premier oscillateur délivrant un premier signal, alors utilisé comme signal de sortie du dispositif oscillateur, à un second oscillateur;
- utiliser un second signal délivré par le second oscillateur comme signal de sortie du dispositif oscillateur;
- commuter le mode de fonctionnement du premier oscillateur du premier mode de fonctionnement au second mode;
- imposer, au moyen d'une seconde boucle à verrouillage de phase, la fréquence de fonctionnement du second oscillateur au premier oscillateur;
- utiliser le premier signal délivré par le premier oscillateur comme signal de sortie du dispositif oscillateur.

Le procédé selon l'invention comporte avantageusement une ou plusieurs caractéristiques supplémentaires, parmi les suivantes:
- le premier oscillateur est un oscillateur haute fréquence à quartz ;
- le second oscillateur est du type oscillateur à capacité et inductance ou à capacité et résistance contrôlé en tension ou encore un oscillateur en anneau contrôlé en tension ;
- le premier mode de fonctionnement correspond à un état de communication du téléphone mobile ;
- le second mode de fonctionnement correspond à un état de veille du téléphone mobile.

La présente invention se rapporte également à un dispositif oscillateur, pour générer une base de temps d'un téléphone mobile en délivrant un signal de sortie, comprenant un premier oscillateur caractérisé en ce qu'il comprend de plus:
- un second oscillateur;
- un premier dispositif d'asservissement de phase imposant la fréquence de fonctionnement du premier oscillateur au second oscillateur;
- un second dispositif d'asservissement de phase imposant la fréquence de fonctionnement du second oscillateur au premier oscillateur;
- un système de contrôle commandant le basculement d'un commutateur entre une première position dans laquelle un premier signal de sortie délivré par le premier oscillateur est utilisé comme signal de sortie du dispositif oscillateur, et une seconde position dans laquelle un second signal de sortie délivré par le second oscillateur est utilisé comme signal de sortie du dispositif oscillateur, la seconde position étant adoptée pendant une opération de commutation du mode de fonctionnement du premier oscillateur d'un premier mode correspondant à un premier niveau de consommation du dispositif à un second mode de fonctionnement correspondant à un second niveau de consommation.

Dans le dispositif selon l'invention, avantageusement, le premier oscillateur est un oscillateur haute fréquence à quartz, et le second oscillateur est du type oscillateur à capacité et inductance ou à capacité et résistance contrôlé en tension ou encore un oscillateur en anneau contrôlé en tension.

L'invention et ses différentes applications seront mieux comprises à la lecture de la description qui suit et à l'examen de la figure qui l'accompagne.

### BREVE DESCRIPTION DE LA FIGURE

Celles-ci ne sont présentées qu'à titre indicatif et nullement limitatif de l'invention. Les figures montrent :
- à la figure 1, déjà décrite, une représentation schématique d'une architecture d'un téléphone mobile de l'état de la technique ;
- à la figure 2, une représentation schématique d'un dispositif oscillateur selon l'invention ;
- à la figure 3, un exemple de réalisation d'un premier oscillateur intervenant dans le dispositif oscillateur selon l'invention.
- aux figures 4-A, 4-B et 4-C, trois exemples de réalisation d'un second oscillateur intervenant dans le dispositif selon l'invention.

### DESCRIPTION DES FORMES DE REALISATION PREFEREES DE L'INVENTION

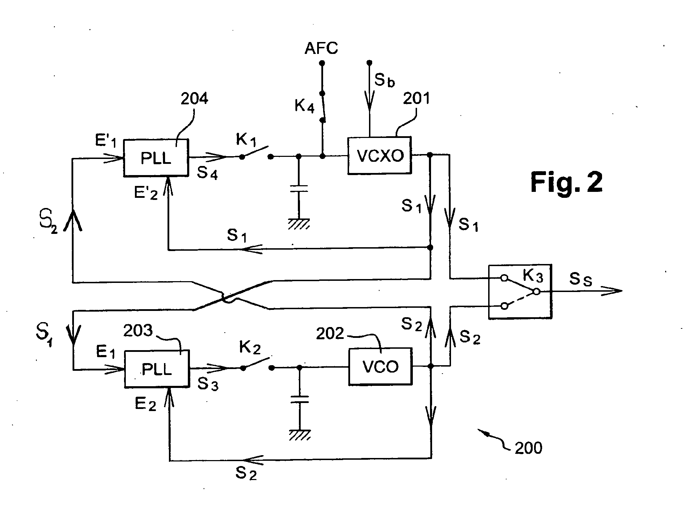

La figure 2 montre un exemple de dispositif oscillateur 200 selon l'invention. Le dispositif oscillateur 200 comporte essentiellement :
- un premier oscillateur 201, capable de délivrer un premier signal haute fréquence S1 très stable et d'une grande pureté spectrale ; le premier oscillateur est un oscillateur à quartz du type VCXO. II reçoit un signal binaire Sb qui lui permet de passer d'un premier mode correspondant à une consommation élevée, à un second mode correspondant à une consommation faible. Par ailleurs, le premier oscillateur 201 reçoit un signal S_{AFC}, dit signal AFC (Automatic Frequency Control en anglais pour Fréquence de contrôle automatique) qui permet à un micro-contrôleur gérant l'ensemble du fonctionnement du dispositif oscillateur 200 d'accorder en permanence la base de temps utilisée dans le téléphone mobile sur une base de temps intervenant dans le réseau de téléphonie sur lequel fonctionne le téléphone. Le signal AFC peut être coupé par l'ouverture d'un interrupteur K4. Dans un exemple, le premier signal S1 a les caractéristiques suivantes :
   - stabilité court terme 0.2 ppm (partie par million) par degré Celsius ;
   - stabilité en température : variation de plus ou moins 7,5 ppm pour une plage de température allant de -20 à + 70 degrés Celsius.
   - précision initiale : plus ou moins 10 ppm.
   - fréquence 13 MHz ou 26 MHz.
- un second oscillateur 202, capable de délivrer un second signal haute fréquence S2, du type oscillateur à capacité et inductance ou à capacité et résistance contrôlé en tension ou encore un oscillateur en anneau contrôlé en tension. Ce dernier type d'oscillateur est constitué de manière connue par un nombre impair d'inverseurs en série; la fréquence d'oscillation est contrôlée par une tension variable appliquée sur la grille d'un FET inséré en série avec chaque inverseur. Le deuxième oscillateur 202 présente une stabilité à très court terme uniquement, par exemple 0,1 ppm pendant 10 millisecondes. Il n'est pas particulièrement stable en température, ne présente pas de pureté spectrale ou de précision initiale comparables à celle du premier oscillateur 201. Sa nature permet de l'intégrer totalement dans un circuit intégré, ce qui résout les problèmes de coût et d'encombrement liés à la présence d'un deuxième oscillateur dans le dispositif oscillateur selon l'invention.
- un commutateur K3, pour utiliser comme signal de sortie Ss du dispositif oscillateur 200 soit le premier signal S1, soit le deuxième signal S2;
- un premier dispositif d'asservissement de phase 203, du type PLL (Phase-lock-loop en anglais, pour boucle à verrouillage de phase), qui reçoit à une première entrée E1 le premier signal S1, et à une deuxième entrée E2 le deuxième signal S2, constituant ainsi une boucle à verrouillage de phase. Le premier dispositif d'asservissement de phase 203 permet d'imposer une fréquence de fonctionnement du premier oscillateur 201 au deuxième oscillateur 202; il fournit un signal de sortie S3 qui est directement transmis au deuxième oscillateur 202.
- un deuxième dispositif d'asservissement de phase 204 du type PULL, qui reçoit à une première entrée E'1 le deuxième signal S2, et à une deuxième entrée E'2 le premier signal S1, constituant ainsi une boucle à verrouillage de phase. Le deuxième dispositif d'asservissement de phase 204 permet d'imposer une fréquence de fonctionnement du deuxième oscillateur 202 au premier oscillateur 201; il fournit un signal de sortie S4 qui est directement transmis au premier oscillateur 201.
- un premier interrupteur K1, disposé sur une liaison reliant le deuxième dispositif d'asservissement de phase 204 au premier oscillateur 201.
- un deuxième interrupteur K2, disposé sur une liaison reliant le premier dispositif d'asservissement de phase 203 au deuxième oscillateur 202.

Un exemple de mise en oeuvre du procédé selon l'invention, directement applicable au dispositif oscillateur 200, est à présent détaillé :
- Etape préliminaire : Lorsque le téléphone mobile est dans un état de communication, la configuration du dispositif oscillateur 200 est la suivante :
   K1 est ouvert, K4 est fermé, K2 est dans une position indifférente ; le signal binaire Sb adopte une première valeur, par exemple 0, correspondant à une consommation élevée du premier oscillateur 201 ; le commutateur K3 est dans une position haute, de telle sorte que le signal de sortie Ss correspond au premier signal S1.
- Lorsque le téléphone entre dans un état de veille, on observe, dans le procédé selon l'invention, une phase transitoire pendant laquelle on respecte différentes étapes :
   - Etape 1 : on ferme K2: le deuxième oscillateur 202 peut ainsi progressivement se caler en fréquence sur la fréquence du premier oscillateur 201.
   - Etape 2 : on ouvre K4 : le premier oscillateur 201 est ainsi isolé ; le deuxième oscillateur 202 a eu le temps de se caler en fréquence sur la fréquence du premier oscillateur 201.
   - Etape 3 : on ouvre K2 : le deuxième oscillateur 202 est ainsi isolé ; il peut ainsi conserver la fréquence qui lui a été imposée par le premier oscillateur 201. On parle ici de mémorisation de la fréquence.
   - Etape 4 : on agit sur le commutateur K3 pour le placer dans une position basse, de telle sorte que le signal de sortie Ss correspond au deuxième signal S2. Le dispositif oscillateur 200 fournit alors au téléphone mobile une base de temps imposée par le deuxième oscillateur 202. On est assuré d'avoir un signal de sortie Ss présentant des caractéristiques acceptables en terme de stabilité et de précision, mais uniquement sur une courte durée.
   - Etape 5 : le signal binaire Sb adopte une deuxième valeur, par exemple 1, correspondant à une consommation faible du premier oscillateur 201 ; on parle de commutation du premier oscillateur 201. Dans le même temps, on ferme K1 de telle sorte que le premier oscillateur 201 peut ainsi progressivement se caler en fréquence sur la fréquence du deuxième oscillateur 202.
   - Etape 6 : on ouvre K1. Le premier oscillateur 201 est ainsi isolé ; il peut ainsi conserver la fréquence qui lui a été imposée par le deuxième oscillateur 202.
   - Etape 7 : on agit sur le commutateur K3 pour le placer de nouveau dans une position haute, de telle sorte que le signal de sortie Ss correspond au premier signal S1. Le dispositif oscillateur 200 fournit alors au téléphone mobile une base de temps de nouveau imposée par le premier oscillateur 201, mais, contrairement à la situation de l'étape préliminaire, le premier oscillateur 201 fonctionne dans un mode basse consommation. On est assuré d'avoir un signal de sortie Ss présentant des caractéristiques irréprochables en terme de stabilité et de précision sur une longue durée. On peut maintenir le mode basse consommation auquel on aboutit dans l'étape 7 tant que le téléphone mobile est dans un état de veille.

Pour sortir de l'état de veille afin de retourner vers un état de communication, qui doit nécessairement être accompagné d'un nouveau changement de mode du premier oscillateur 201 pour le faire passer d'un mode faible consommation à un mode consommation élevée, on respecte les opérations décrites, dans l'ordre qui vient d'être donné, dans les étapes 1 à 7. La seule différence se situe au niveau de l'étape 5 dans laquelle le signal binaire Sb adopte lors la première valeur, correspondant à une consommation élevée du premier oscillateur 201. On aboutit ainsi à l'étape 7 dans laquelle le dispositif oscillateur 200 fournit au téléphone mobile une base de temps de nouveau imposée par le premier oscillateur 201 fonctionnant dans un mode consommation élevée. On est toujours assuré d'avoir un signal de sortie Ss présentant des caractéristiques irréprochables en terme de stabilité et de précision sur une longue durée. On maintient l'état auquel on aboutit dans l'étape 7 tant que le téléphone mobile est dans un état de communication.

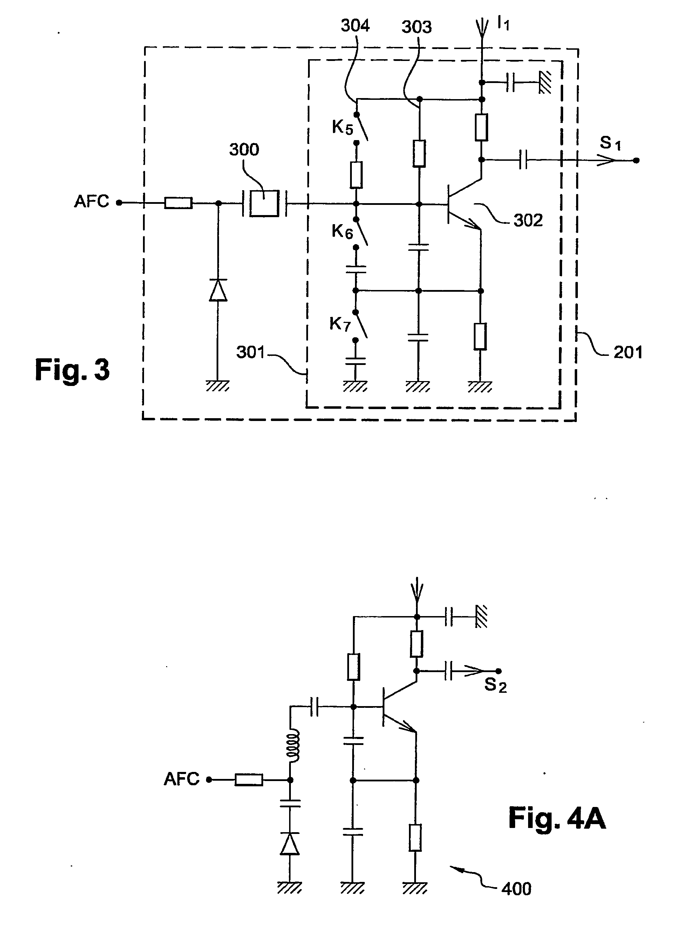

La figure 3 montre un exemple de réalisation d'un premier oscillateur 201 capable d'être utilisé dans le procédé et le dispositif oscillateur selon l'invention. Le premier oscillateur 201 reçoit en entrée le signal AFC et fournit en sortie le premier signal S1. II comporte notamment un quartz 300 associé à un circuit électronique 301 comportant notamment un transistor de type MOSFET 302 et un ensemble de composants électroniques permettant d'obtenir le premier signal S1 à la fréquence voulue.

L'ensemble de composants électroniques est essentiellement constitué d'une première branche de composants 303 et d'une deuxième branche de composants 304. Lorsque le premier oscillateur 201 est dans un mode de forte consommation, la première branche et la deuxième branche de composants interviennent dans le circuit électronique 301 pour élaborer le premier signal S1; on assure ainsi une forte robustesse vis à vis des courants perturbateurs qui circulent dans le téléphone mobile quand celui-ci est dans un mode de communication.

Lorsque une intensité d'un courant I1, fourni au drain du transistor 302, est diminuée, ce qui se produit lorsque l'on passe du mode consommation élevée au mode faible consommation, on ouvre un ensemble d'interrupteurs, référencés K5, K6 et K7 dans l'exemple illustré, de telle sorte que les composants de la deuxième branche 304 n'interviennent plus dans le circuit électronique 301 pour élaborer le premier signal S1. On augmente ainsi l'aptitude du premier oscillateur 201 à osciller à courant faible.

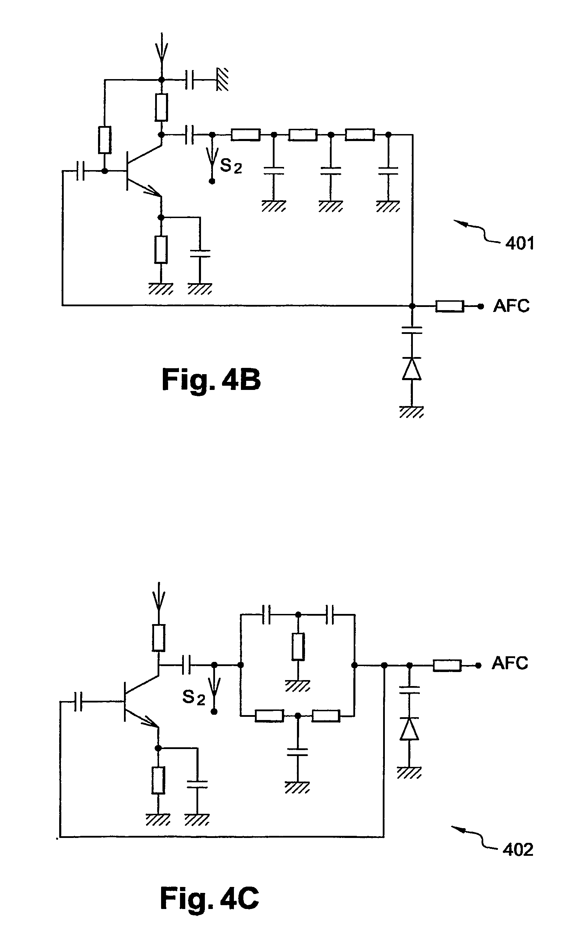

Les figures 4-A, 4-B et 4-C montrent respectivement un premier exemple 401, un deuxième exemple 402 et un troisième exemple 403 d'oscillateurs qui peuvent être utilisés comme second oscillateur 202 dans l'exemple de réalisation de l'invention décrit à la figure 2.

## Revendications

1. Procédé de commutation de mode d'un dispositif oscillateur (200), pour générer une base de temps d'un téléphone mobile en délivrant un signal de sortie (Ss), pour passer d'un premier mode de fonctionnement, correspondant à un premier niveau de consommation, à un second mode de fonctionnement, correspondant à un second niveau de consommation, le second niveau de consommation étant inférieur au premier niveau de consommation **caractérisé en ce qu'**il comporte une phase de transition, lors du passage du premier mode au second mode, comportant les différentes étapes consistant à:
- imposer, au moyen d'une première boucle à verrouillage de phase, une fréquence de fonctionnement d'un premier oscillateur (201) délivrant un premier signal (S1), alors utilisé comme signal de sortie (Ss) du dispositif oscillateur (200), à un second oscillateur (202);
- utiliser un second signal (S2) délivré par le second oscillateur (202) comme signal de sortie (Ss) du dispositif oscillateur (200);
- commuter le mode de fonctionnement du premier oscillateur (201) du premier mode de fonctionnement au second mode;
- imposer, au moyen d'une seconde boucle à verrouillage de phase, la fréquence de fonctionnement du second oscillateur (202) au premier oscillateur (201);
- utiliser le premier signal (S1) délivré par le premier oscillateur (201) comme signal de sortie (Ss) du dispositif oscillateur (200).

2. Procédé selon la revendication précédente **caractérisé en ce que** le premier oscillateur (201) est un oscillateur haute fréquence à quartz.

3. Procédé selon l'une au moins des revendications précédentes **caractérisé en ce que** le second oscillateur (202) est du type oscillateur à capacité et inductance ou à capacité et résistance contrôlé en tension ou un oscillateur en anneau contrôlé en tension .

4. Procédé selon l'une au moins des revendications précédentes **caractérisé en ce que** le premier mode de fonctionnement correspond à un état de communication du téléphone mobile.

5. Procédé selon l'une au moins des revendications précédentes **caractérisé en ce que** le second mode de fonctionnement correspond à un état de veille du téléphone mobile.

6. Dispositif oscillateur (200), pour générer une base de temps d'un téléphone mobile en délivrant un signal de sortie (Ss), comprenant un premier oscillateur (201) **caractérisé en ce qu'**il comprend de plus:
- un second oscillateur (202);
- un premier dispositif d'asservissement de phase (203) agencé pour imposer la fréquence de fonctionnement du premier oscillateur (201) au second oscillateur (202);
- un second dispositif d'asservissement de phase (204) agencé pour imposer la fréquence de fonctionnement du second oscillateur (202) au premier oscillateur (201);
- un système de contrôle agencé pour commander le basculement d'un commutateur (K3) entre une première position dans laquelle un premier signal de sortie (S1) délivré par le premier oscillateur (201) est utilisé comme signal de sortie (Ss) du dispositif oscillateur (200), et une seconde position dans laquelle un second signal de sortie (S2) délivré par le second oscillateur (202) est utilisé comme signal de sortie (Ss) du dispositif oscillateur (200), la seconde position étant adoptée pendant une opération de commutation du mode de fonctionnement du premier oscillateur (201) d'un premier mode correspondant à un premier niveau de consommation du dispositif à un second mode de fonctionnement correspondant à un second niveau de consommation.

7. Dispositif oscillateur selon la revendication précédente **caractérisé en ce que** le premier oscillateur (201) est un oscillateur haute fréquence à quartz.

8. Dispositif oscillateur selon l'une au moins des revendications 6 ou 7, **caractérisé en ce que** le second oscillateur (202) est du type oscillateur à capacité et inductance ou à capacité et résistance contrôlé en tension ou un oscillateur en anneau contrôlé en tension.

## Claims

1. Mode switching method for an oscillator device (200), for generating a mobile telephone time base while supplying an output signal (Ss), in order to change from a first operating mode, corresponding to a first consumption level, to a second operating mode, corresponding to a second consumption level, the second consumption level being below the first consumption level, **characterised in that** it comprises a transitional phase, during the change from the first mode to the second mode, comprising the different steps of:
- imposing, by means of a first phase locking loop, an operating frequency of a first oscillator (201) delivering a first signal (S1), thus used as the output signal (Ss) from the oscillator device (200), on a second oscillator (202);
- using a second signal (S2) delivered by the second oscillator (202) as the output signal (Ss) from the oscillator device (200);
- switching the operating mode of the first oscillator (201) from the first operating mode to the second mode;
- imposing the operating frequency of the second oscillator (202) on the first oscillator (201) by means of a second phase locking loop;
- using the first signal (S1) delivered by the first oscillator (201) as the output signal (Ss) from the oscillator device (200).

2. Method according to the preceding claim, **characterised in that** the first oscillator (201) is a high frequency quartz oscillator.

3. Method according to at least one of the preceding claims, **characterised in that** the second oscillator (202) is an oscillator of the voltage-controlled capacitance and inductance type or of the voltage-controlled capacitance and resistance type or a voltage-controlled ring oscillator.

4. Method according to at least one of the preceding claims, **characterised in that** the first operating mode corresponds to a communicating state of the mobile telephone.

5. Method according to at least one of the preceding claims, **characterised in that** the second operating mode corresponds to a standby state of the mobile telephone.

6. Oscillator device (200) for generating a mobile telephone time base while supplying an output signal (Ss), comprising a first oscillator (201), **characterised in that** it further comprises:
- a second oscillator (202);
- a first phase servo device (203) arranged so as to impose the operating frequency of the first oscillator (201) on the second oscillator (202);
- a second phase servo device (204) arranged so as to impose the operating frequency of the second oscillator (202) on the first oscillator (201);
- a monitoring system arranged so as to control the toggling of a switch (K3) between a first position in which a first output signal (S1) delivered by the first oscillator (201) is used as an output signal (Ss) of the oscillator device (200), and a second position in which a second output signal (52) delivered by the second oscillator (202) is used as an output signal (Ss) of the oscillator device (200), the second position being adopted during an operation to switch the operating mode of the first oscillator (201) from a first mode corresponding to a first consumption level of the device to a second operating mode corresponding to a second consumption level.

7. Oscillator device according to the preceding claim, **characterised in that** the first oscillator (201) is a high frequency quartz oscillator.

8. Oscillator device according to at least one of claims 6 or 7, **characterised in that** the second oscillator (202) is an oscillator of the voltage-controlled capacitance and inductance type or of the voltage-controlled capacitance and resistance type or a voltage-controlled ring oscillator.

## Patentansprüche

1. Verfahren zum Moduswechsel einer Oszillatorvorrichtung (200) für die Generierung einer Zeitbasis eines Mobiltelefons durch Erzeugung eines Ausgangsignals (Ss), zum Wechseln von einem ersten Betriebsmodus, der einem ersten Verbrauchswert entspricht, in einen zweiten Betriebsmodus, der einem zweiten Verbrauchswert entspricht, wobei der zweite Verbrauchswert niedriger als der erste Verbrauchswert ist,
**dadurch gekennzeichnet, dass**
das Verfahren während des Wechsels vom ersten Modus in den zweiten Modus eine Übergangsphase umfasst, die die folgenden unterschiedlichen Schritte aufweist:
- Aufzwingen (Anlegen /Aufmodellieren) einer Betriebsfrequenz eines ersten Oszillators (201), der ein erstes Signal (S1) erzeugt, das als Ausgangssignal (Ss) der Oszillatorvorrichtung (200) verwendet wird, mithilfe einer ersten Phasenrückkoppelungsschleife an einen zweiten Oszillator (202);
- Verwenden eines zweiten Signals (S2), das vom zweiten Oszillator (202) erzeugt wird, als Ausgangssignal (Ss) der Oszillatorvorrichtung (200);
- Wechseln des Betriebsmodus des ersten Oszillators (201) vom ersten Betriebsmodus in den zweiten Modus;
- Aufzwingen der Betriebsfrequenz des zweiten Oszillators (202) auf den ersten Oszillator (201) mithilfe einer zweiten Phasenrückkoppelungsschleife;
- Verwenden des ersten Signals (S1), das vom ersten Oszillator (201) erzeugt wird, als Ausgangssignal (Ss) der Oszillatorvorrichtung (200).

2. Verfahren nach dem vorangehenden Anspruch,
**dadurch gekennzeichnet, dass**
der erste Oszillator (201) ein Hochfrequenzquarzoszillator ist.

3. Verfahren nach wenigstens einem der vorangehenden Ansprüche,
**dadurch gekennzeichnet, dass**
es sich bei dem zweiten Oszillator (202) um einen nach Spannung geregelten Kapazität / Induktivität- oder Kapazität / Widerstand- Oszillator handelt oder es sich bei dem zweiten Oszillator (202) um einen nach Spannung geregelten Ringoszillator handelt.

4. Verfahren nach wenigstens einem der vorangehenden Ansprüche,
**dadurch gekennzeichnet, dass**
der erste Betriebsmodus einem Kommunikationszustand des Mobiltelefons entspricht.

5. Verfahren nach wenigstens einem der vorangehenden Ansprüche,
**dadurch gekennzeichnet, dass**
der zweite Betriebsmodus einem Stand-by-Modus des Mobiltelefons entspricht.

6. Oszillatorvorrichtung (200) zur Erzeugung einer Zeitbasis eines Mobiltelefons durch Erzeugung eines Ausgangssignals (Ss), aufweisend einen ersten Oszillator (201),
**dadurch gekennzeichnet, dass**
die Vorrichtung weiterhin aufweist:
- einen zweiten Oszillator (202);
- eine erste Phasensteuerungsvorrichtung (203), die dazu ausgelegt ist, dem zweiten Oszillator (202) die Betriebsfrequenz des ersten Oszillators (201) aufzuzwingen;
- eine zweite Phasensteuerungsvorrichtung (204), die dazu ausgelegt ist, dem ersten Oszillator (201) die Betriebsfrequenz des zweiten Oszillators (202) aufzuzwingen;
- ein Regelungssystem, das zum Steuern des Umschaltens eines Kommutators (K3) zwischen einer ersten Stellung, in der ein erstes Ausgangssignal (S1), das durch den ersten Oszillator (201) erzeugt wird, als Ausgangssignal (Ss) der Oszillatorvorrichtung (200) verwendet wird, und einer zweiten Stellung, in der ein zweites Ausgangssignal (S2), das durch den zweiten Oszillator (202) erzeugt wird, als Ausgangssignal (Ss) der Oszillatorvorrichtung (200) verwendet wird, ausgelegt ist, wobei die zweite Stellung während eines Umschaltbetriebs des Betriebsmodus des ersten Oszillators (201) von einem ersten Modus entsprechend einem ersten Verbrauchswert der Vorrichtung in einen zweiten Betriebsmodus entsprechend einem zweiten Verbrauchswert eingenommen wird.

7. Oszillatorvorrichtung nach dem vorangehenden Anspruch,
**dadurch gekennzeichnet, dass**
der erste Oszillator (201) ein Hochfrequenzquarzoszillator ist.

8. Oszillatorvorrichtung nach wenigstens einem der Ansprüche 6 oder 7,
**dadurch gekennzeichnet, dass**
es sich bei dem zweiten Oszillator (202) um einen nach Spannung geregelten Kapazität / Induktivität- oder Kapazität- / Widerstand-Oszillator handelt oder es sich bei dem zweiten Oszillator (202) um einen nach Spannung geregelten Ringoszillator handelt.
